Europäisches Patentamt

(19) European Patent Office

Office européen des brevets

(11) Numéro de publication : **0 265 472 B1**

(12) # FASCICULE DE BREVET EUROPEEN

(45) Date de publication du fascicule du brevet :
**18.12.91 Bulletin 91/51**

(51) Int. Cl.⁵ : **H03K 17/969**

(21) Numéro de dépôt : **87902559.1**

(22) Date de dépôt : **27.04.87**

(86) Numéro de dépôt international :
**PCT/FR87/00141**

(87) Numéro de publication internationale :
**WO 87/06782 05.11.87 Gazette 87/24**

(54) **CLAVIER OPTIQUE A SENSIBILITE ACCRUE.**

(30) Priorité : **25.04.86 FR 8606067**

(43) Date de publication de la demande :
**04.05.88 Bulletin 88/18**

(45) Mention de la délivrance du brevet :
**18.12.91 Bulletin 91/51**

(84) Etats contractants désignés :
**AT BE CH DE FR GB IT LI LU NL SE**

(56) Documents cités :
**EP-A- 0 004 520**
**EP-A- 0 054 644**
**EP-A- 0 181 612**

(56) Documents cités :
**US-A- 4 319 144**
**Electronique et applications Industrielles, n0
255, June 1978 (Paris, FR), P. Vernel et al.:
"Clavier à voter à faisceaux infrarouges",
pages 57-59**

(73) Titulaire : **SOULOUMIAC, Alain**
**29, rue du Général Brunet**
**F-75019 Paris (FR)**

(72) Inventeur : **SOULOUMIAC, Alain**
**29, rue du Général Brunet**
**F-75019 Paris (FR)**

(74) Mandataire : **Viard, Jean**
**Cabinet VIARD 28 bis, avenue Mozart**
**F-75016 Paris (FR)**

## Description

La présente invention concerne l'électronique des claviers optiques à balayage matriciel utilisés comme terminaux d'entrée, des machines bureautiques et des instruments de musique par exemple.

Les touches des claviers optiques à balayage matriciel sont disposées selon une matrice logique d'entrées et de sorties de lumière formée de trajets optiques, chaque touche agissant sur un trajet optique particulier allant d'une entrée vers une sortie de lumière. L'action d'une touche modifie l'état du couple entrée/sortie sur son trajet spécifique, et le circuit pilote de balayage connecté auxdites entrées et sorties détecte le changement intervenu. Cette scrutation s'opère en injectant à tour de rôle dans chaque série d'entrées de lumière un signal d'interrogation et en observant l'état de toutes les sorties pour détecter laquelle d'entre elles a éventuellement été affectée par la touche qui lui est associée.

Il importe d'inspecter toutes les touches assez souvent afin d'être sûr que lorsque l'utilisateur appuiera l'une d'entre elle, il sera impossible que le fait échappe au circuit pilote en scrutation. Quand une action est détectée le circuit pilote de balayage doit accomplir deux fonctions : continuer à scruter le clavier tout en suivant le déroulement des opérations concernant la touche qui est en action et rapporter les étapes de ce déroulement à l'équipement que sert le clavier.

Cette vitesse dépend de plusieurs facteurs, notamment de la puissance et la rapidité des sources de lumière et surtout de la sensibilité et la rémanence des moyens de détection.

Des solutions pour améliorer les sensibilités de claviers optiques ont déjà été proposées.

EP-A-0 004 520 décrit un clavier dans lequel la sensibilité des photodétecteurs est considérée comme une donnée fixe et il est proposé de focaliser les faisceaux et d'accroître le coefficient de transmission en prévoyant des revêtements diélectriques anti-réflexion.

Dans la revue "Electronique et Applications industrielles" no. 255-juin 1978, pages 57-59, Paris est décrit un un moyen pour accroître la sensibilité au signal reçu, qui consiste à accroître la tension appliquée sur des photodiodes d'un clavier à matrice logique.

Dans US-A-4 319 144, les signaux optiques sont puissants et continus et détectés par des transistors à effet de champ. Des diodes n'ont pour but que de polariser la gâchette au potentiel de seuil.

Les réalisations préférentielles de la présente invention visent à définir les moyens d'accroître l'efficacité et la fiabilité du circuit pilote en accroissant la sensibilité des moyens de détection, moyens autres que ceux connus de l'art antérieur cité.

Selon la présente invention, le clavier optique à balayage matriciel à sensibilité accrue comportant d'une part, une matrice logique de trajets optiques entre des entrées et des sorties de lumière, des touches étant disposées sur chaque trajet optique liant les entrées et les sorties de telle sorte que l'enfoncement d'une touche produit un changement de couplage optique entre l'entrée et la sortie de lumière du trajet concerné et d'autre part, un circuit pilote de balayage ayant des émetteurs de lumière connectés auxdites entrées de lumière et des photodétecteurs connectés auxdites sorties de lumière pour détecter des variations du flux lumineux reçu de signaux lumineux d'interrogation injectés périodiquement dans chaque entrée de lumière selon un cycle prédéterminé et en scrutant chaque sortie de lumière pour détecter la présence d'éventuels changements de couplage optique, ledit clavier étant caractérisé en ce qu'il comporte des moyens capables pour un niveau donné de lumière reçue, d'accroître la sensibilité dudit circuit pilote, moyens autres qu'agissant sur la tension appliquée auxdits photodétecteurs.

Un des premiers moyens capables d'accroître la sensibilité dudit circuit pilote est d'augmenter le temps de scrutation de chacun des photodétecteurs. Mais ce premier moyen présente le défaut de ralentir la vitesse de scrutation du clavier. C'est pourquoi la présente invention propose de réduire l'inconvénient inhérent à ce premier moyen en faisant varier le rythme de scrutation du clavier en fonction de la sensibilité de détection, soit de chaque composant, soit du plus lent d'entre eux.

Ce rythme variable de scrutation est rendu possible sur les claviers optiques par l'absence de rebond qui les caractérise. La présence de routines anti-rebonds, obéissant à un rythme fixe, fonction du temps attendu des rebonds, devient inutile. Comme la contrainte temps réel n'existe pas pour les claviers optiques, les difficultés de faire varier le rythme des balayages sont réduites ou éliminées.

Dans un clavier optique, les sorties de lumière conduisant aux transducteurs optoélectroniques connectés au circuit pilote de balayage peuvent être sollicitées au début de cycle de balayage par un pré-signal envoyé à tous lesdits transducteurs afin de vérifier que tous les transducteurs répondent effectivement, de déterminer le temps mis par le premier d'entre eux à répondre et le dernier d'entre eux à redescendre en dessous d'un seuil déterminé à l'avance, (et donc vérifier le bon fonctionnement desdits transducteurs), et d'établir le plus court temps d'intervalle qui doit être alloué entre les signaux successifs d'interrogation qui sont envoyés.

Une autre manière de gagner du temps, et donc d'accroître le temps disponible pour les opérations de scrutation et d'augmenter la sensibilité des récepteurs, est d'en perdre le moins possible dans les opérations d'identification, de codage et de transmission des messages émis par le clavier. Elle consiste à adopter un positionnement préférentiel des touches dites "combinatoires" -comme la touche "contrôle" ou la touche "majuscule"- dans la matrice de scrutation. Comme ces touches "combinatoires" ont vocation à se combiner avec d'autres touches, il est souhaitable de faire en sorte que ces touches se trouvent de préférence dans la première séquence de balayage des sources de lumière.

Plusieurs modes de réalisations de ce clavier optique sont décrits, à titre d'exemple, en faisant référence aux dessins annexés parmi lesquels :
- la figure 1 indique le schéma de principe qui régit le fonctionnement du circuit pilote de balayage;
- la figure 2 représente un premier type de clavier optique soumis à un pré-signal;
- la figure 3 représente un second type de clavier optique soumis à un pré-signal;
- la figure 4 représente une capacité alimentant les transducteurs émetteurs de lumière;
- la figure 5 représente un circuit élémentaire pour la détection d'une impulsion lumineuse avec stockage de l'information sur la capacité parasite d'entrée.

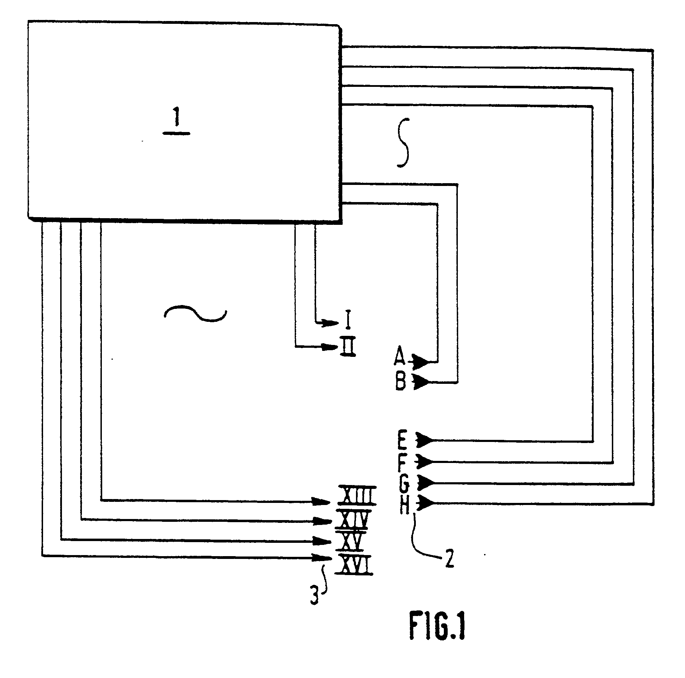

La figure 1 indique le schéma de principe du fonctionnement du circuit pilote de balayage 1. En un temps T1, il allume une source lumineuse 3 (I) dont la lumière est dirigée vers plusieurs photodétecteurs 2 (ABC..GH). Chacun d'eux reçoit l'énergie lumineuse et le témoigne au circuit pilote en lui renvoyant un courant qui s'élève au-dessus d'un seuil d'excitation déterminé. Le résultat de cette scrutation est traité par le circuit pilote. Puis dans le temps T2, c'est la source lumineuse suivante II dans la séquence qui est mise en opération, et ainsi de suite, jusqu'à l'allumage de la dernière source lumineuse (XVI) qui marque la fin d'un cycle de scrutations de tout le clavier.

On sait que les énergies reçues par les photodétecteurs peuvent varier dans des proportions sensibles et que le temps de restitution des informations peut également varier selon les composants et l'énergie reçue. Une méthode pour s'affranchir de ces contraintes consiste à se donner des marges de sécurité du type doublement ou triplement du temps d'émission nécessaire pour obtenir un signal sur un composant de qualité médiocre. Sans apporter de certitude absolue, cette méthode fournit une garantie assez sérieuse de ne pas voir le signal ignoré dans le pire des cas. Mais une telle solution présente l'inconvénient d'être par définition lente et consommatrice d'énergie.

Une des solutions préférées dans la présente réalisation consiste à prendre comme début de chaque cycle de balayage d'une source de lumière le moment où le plus lent des photodétecteurs est apte à recevoir une nouvelle information de manière fiable. Cet instant est déterminé grâce à une mesure des tensions résiduelles aux bornes des photodétecteurs en référence à un seuil de désexcitation.

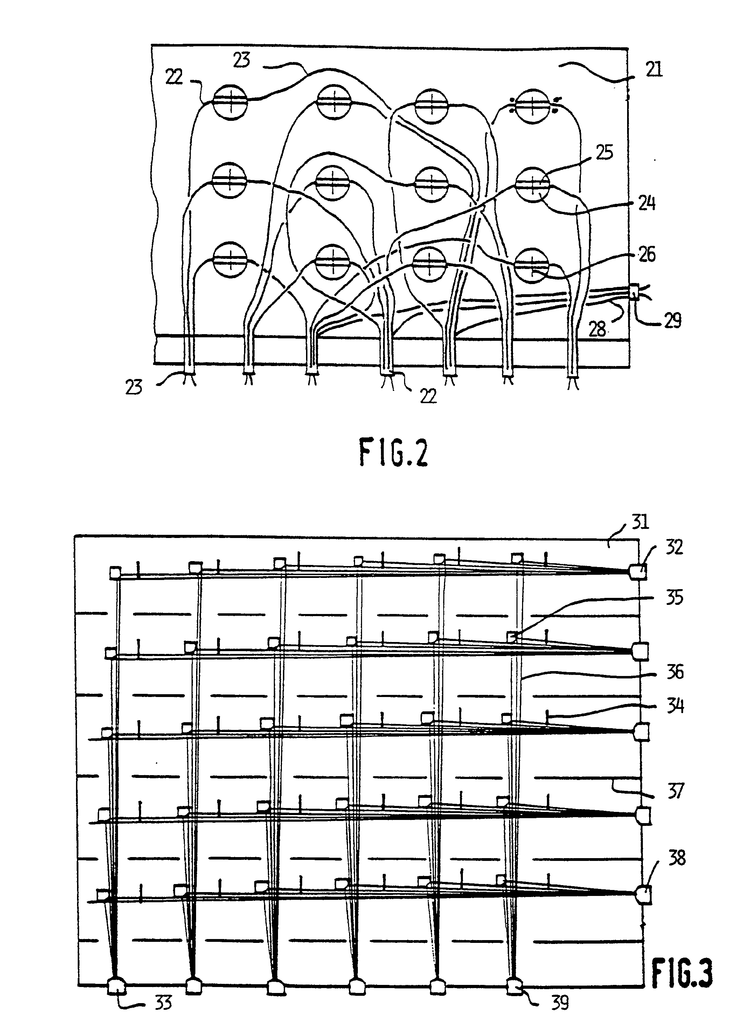

Un pré-signal 29 (Fig.2) peut être utilisé pour effectuer cette mesure et vérifier le bon fonctionnement du clavier en analysant les réactions des photodétecteurs. Ce signal lumineux est envoyé sur les photodétecteurs jusqu'au moment où tous ont franchi un seuil d'excitation déterminé. Une fois ce seuil atteint, on s'assure que tous les photodétecteurs reviennent bien au seuil de désexcitation.

Si le fonctionnement d'un ou plusieurs photodétecteurs s'avère défaillant au cours d'une de ces mesures un message d'erreur peut être envoyé vers le système auquel le clavier est connecté.

Un exemple de réalisation du pré-signal de vérification est représenté par la figure 2. Il concerne un clavier optique comprenant un boîtier rectangulaire 21 parcouru de couples de fibres 23, 22 dont l'une amène la lumière et l'autre rapporte le signal. Ces deux fibres se rejoignent vers un interrupteur 25 commandé par une touche.

Ce pré-signal est ici réalisé en prévoyant des fibres spécifiques. A la différence des fibres ordinaires, les fibres spécifiques 28 qui permettent à la source lumineuse d'émettre un signal sur les transducteurs récepteurs ne sont pas sectionnées. Lorsque la source lumineuse 29 envoie un pré-signal tous les récepteurs sont donc directement illuminés quelque que soit l'état des touches. Ainsi on peut aussi bien mesurer les temps de réaction des différents récepteurs, déterminer quel est le premier à s'activer et quel est le dernier à se désactiver, aussi bien qu'accentuer la sensibilité des récepteurs avant l'envoi du signal de détection sur les sources de lumière 23.

Un autre mode de réalisation (Fig.3) concerne un clavier à miroirs fixes. Il se compose d'un boîtier creux 31 ceinturé de plusieurs bords dans lequel sont inclus des caches 37. Dans l'exemple présenté par la figure 3, le bloc optique est rectangulaire. Deux de ses bords adjacents comportent des moyens lumineux 33 et des éléments de détection 32. Pour accroître la puissance et la sensibilité de l'ensemble, il est possible de réduire les distances et d'implanter des composants d'émission ou de détection sur le troisième, et voire le quatrième bord du boîtier, ce qui revient en fait à implanter plusieurs matrices sur le même bloc optique. Une meilleure exploitation de l'énergie émise peut également résulter de l'implantation de deux rangées de miroirs (non représentées formant un angle donné face à chaque source de lumière.

Les réflecteurs se trouvent disposés à l'intérieur du support en un point proche des intersections des rangées d'émission et des colonnes de détecteurs. La lumière 36 est renvoyée des colonnes 33 vers des rangées 32 grâce à des réflecteurs de petites dimensions 35 placés de sorte à ce qu'ils ne se gênent pas mutuellement. Lorsqu'une touche 34 est enfoncée, elle provoque l'obturation d'un de ces réflecteurs ou au contraire le libère de son obturateur.

Dans cette réalisation, il est possible de prévoir une source de lumière de présignalisation 39 et de lui réserver un trajet optique de présignalisation qui ne peut être interrompu par aucune touche. Une sortie de vérification similaire 38 (Fig.3) peut être amenée pour s'assurer du bon fonctionnement des sources de lumière grâce à l'adjonction d'un photodétecteur spécifique, qui lors de la mise en opération de chacune des sources de lumière pourra constater leur bon fonctionnement.

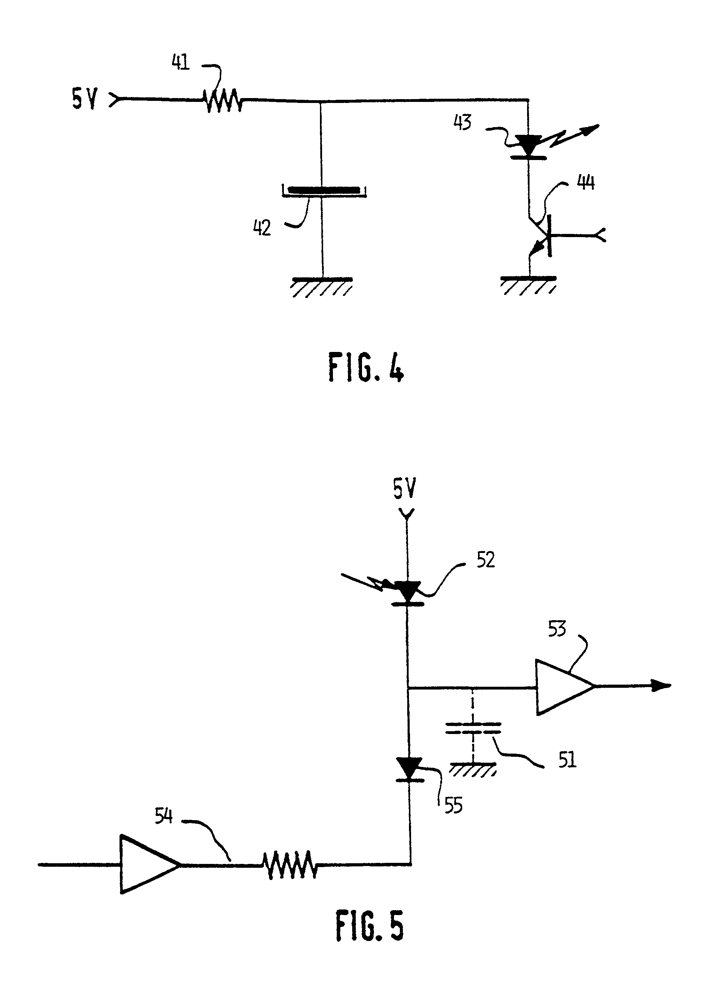

Les figures 4 et 5 décrivent d'autres manières d'abréger les temps et d'améliorer la fiabilité des signaux en augmentant la puissance des sources de lumière et la sensibilité des composants. La figure 4 donne un exemple de réalisation permettant d'accroître très sensiblement la puissance de l'émission d'une source de lumière 43 grâce à la présence d'un condensateur réservoir 42 servant de source de grande puissance instantanée. Une résistance de limitation du courant 41 est prévue dans le circuit pour permettre la recharge du condensateur réservoir 42 avant l'impulsion suivante. Un commutateur du type transitor 44 déclenche la décharge du condensateur réservoir 42 au travers de la source lumineuse 43, qui ici est une diode LED, lorsqu'une impulsion de commande est envoyée sur sa base.

La figure 5 fournit un exemple de réalisation permettant d'accroître la sensibilité des photodétecteurs : au moyen d'un circuit de RAZ 54, la capacité parasite d'entrée 51 est déchargée à une tension de référence, telle que 0 volt au travers d'un dispositif commutateur tel qu'une diode ou un relais CMOS 53 sous la commande d'un signal de remise à zéro. Puis le circuit de RAZ 54 revient à une tension de travail, telle que 5 volts, et la diode 55 se trouve bloquée. Dans le cas où la photodiode 52 ne reçoit pas de lumière, la capacité 51 demeure à 0 volt. Au moment où elle reçoit une impulsion lumineuse, la capacité 51 se charge à 5 volts et reste chargée jusqu'au prochain signal de remise à zéro. La sortie de l'ampli MOS 53 restitue en sortie l'état de la tension sur la capacité 51.

D'autres moyens supplémentaires peuvent être mis en oeuvre pour accroître la sensibilité des photodétecteurs, notamment dans l'hypothèse où des transistors de détection sont utilisés. Alors que la plupart de l'électronique est alimentée en des tensions telle 5 volts environ, il apparaît préférable d'alimenter les transducteurs récepteurs optiques avec un voltage plusieurs fois supérieur afin d'augmenter leur sensibilité comme en soi connu.

## Revendications

1. Clavier optique à balayage matriciel à sensibilité accrue comportant d'une part une matrice logique de trajets optiques entre des entrées et des sorties de lumière, des touches étant disposées sur chaque trajet optique liant les entrées et les sorties de telle sorte que l'enfoncement d'une touche produit un changement de couplage optique entre l'entrée et la sortie de lumière du trajet concerné, et d'autre part un circuit pilote de balayage ayant des émetteurs de lumière connectés auxdites entrées de lumière et des photodétecteurs connectés auxdites sorties de lumière pour détecter des variations du flux lumineux reçu de signaux lumineux d'interrogation injectés périodiquement dans chaque entrée de lumière selon un cycle prédéterminé et en scrutant chaque sortie de lumière pour détecter la présence d'éventuels changements de couplage optique, ledit clavier étant caractérisé en ce qu'il comporte des moyens capables pour un niveau donné de lumière reçue, d'accroître la sensibilité dudit circuit pilote, moyens autres qu'agissant sur la tension d'alimentation appliquée ausdits détecteurs.

2. Clavier optique selon la revendication 1, caractérisé en ce que lesdits moyens capables d'accroître la sensibilité du circuit pilote sont réalisés par des moyens aptes à allonger la durée de scrutation, cette durée étant optimisée en augmentant un rythme de balayage variable jusque à une vitesse trop élevée pour le bon fonctionnement du clavier, puis en réduisant ce rythme suffisamment pour retrouver un fonctionnement correct.

3. Clavier optique selon la revendication 2, caractérisé en ce que, en l'absence d'enfoncement des touches, le circuit pilote injecte chaque signal d'interrogation dans l'entrée de lumière suivante dans le cycle dès que le plus lent des photodétecteurs est prêt à recevoir une nouvelle information.

4. Clavier optique selon l'une des revendications 1 à 3, caractérisé en ce qu'il comprend des moyens pour appliquer sur les sorties un pré-signal lumineux d'augmentation de sensibilité, préparant ainsi les photodétecteurs à la réception des signaux optiques transmettant de l'information.

5. Clavier optique selon la revendication 4, caractérisé en ce que lesdits moyens d'application d'un pré-signal lumineux comportent une entrée supplémentaire d'injection de lumière connectée à chacune desdites sorties par des trajets optiques permanents continus.

6. Clavier optique selon l'une des revendications 4 et 5, caractérisé en ce que lesdits moyens d'application d'un pré-signal lumineux appliquent ledit signal au début de chaque cycle de scrutation du clavier.

7. Clavier optique selon l'une des revendications 1 à 6, caractérisé en ce que certaines des touches, dites "combinatoires", sont associées avec des trajets optiques de telle manière que leur état est examiné au début de chaque cycle de scrutation du clavier, permettant ainsi d'accélérer la scrutation ultérieure à l'intérieur dudit cycle dans la mesure où il n'y a pas besoin de retenir des informations concernant les autres touches, dites "non-combinatoires", jusqu'à ce qu'on ait scruté toutes les touches combinatoires.

8. Clavier optique selon l'une des revendications 2 à 7, caractérisé en ce que lesdits moyens capables d'accroître la sensibilité du circuit pilote comportent une alimentation des photodétecteurs avec une tension plusieurs fois supérieure à la tension de référence du restant du circuit pilote.

9. Clavier optique selon l'une des revendications 1 à 8, caractérisé en ce que sur chaque sortie est connectée une photodiode constituant le photodétecteur, ladite photodiode étant connectée en sortie à un circuit MOS dont elle charge la capacité d'entrée d'une part, et un circuit de décharge de ladite capacité sous la commande d'un signal de remise à zéro d'autre part.

**Patentansprüche**

1. Optische Tastatur für matrizenförmige Abtastung mit erhöhter Empfindlichkeit, die einerseits eine logische Matrix von optischen Pfaden zwischen Lichteingängen und Lichtausgängen und Tasten enthält, die in jedem optischen Pfad angeordnet sind und die Eingänge und die Ausgänge derart verbinden, daß die Betätigung einer Taste eine Veränderung der optischen Verbindung zwischen dem Lichteingang und dem Lichtausgang des betreffenden Pfades erzeugt, und die andererseits einen Abtast-Steuerkreis enthält, der mit besagten Lichteingängen verbundene Lichtsender und mit besagten Lichtausgängen. verbundene Photosensoren enthält, um Veränderungen des Lichtflusses von empfangenen Abfrage-Lichtsignalen zu detektieren, die periodisch nach einem vorgegebenen Zyklus auf jeden Lichteingang gegeben und an jedem Lichtausgang überprüft werden, um das Auftreten eventueller Änderungen der optischen Verbindung zu detektieren, dadurch gekennzeichnet, daß die Tastatur Mittel enthält, die geeignet sind, für ein vorgegebenes Niveau des empfangenen Lichtes die Empfindlichkeit des besagten Steuerkreises zu erhöhen, wobei es sich um andere Mittel als zum Einwirken auf die an die besagten Sensoren angelegte Versorgungsspannung handelt.

2. Optische Tastatur nach Anspruch 1, dadurch gekennzeichnet, daß die zum Erhöhen der Empfindlichkeit des Steuerkreises geeignete Mittel als mittel ausgebildet sind, die fähig sind, die Überprüfungsdauer zu verlängern, die dadurch optimiert wird, daß der variable Abtastrythmus bis zu einer Geschwindigkeit vergröbert wird, die für eine gute Funktion der Tastatur zu hoch ist, wonach der Rythmus genügend reduziert wird, um eine korrekte Funktion wiederzufinden.

3. Optische Tastatur nach Anspruch 2, dadurch gekennzeichnet, daß bei fehlender Betätigung der Tasten der Steuerkreis jedes Abfragesignal in den im Zyklus folgenden Lichteintritt eingibt, bis der langsamste Photosensor bereit ist, eine neue Information aufzunehmen.

4. Optische Tastatur nach einem der Ansprüche 1 bis 3, dadurch gekennzeichnet, daß sie Mittel enthält, um an die Ausgänge zum Erhöhen der Empfindlichkeit ein Licht-Vorsignal anzulegen, womit die Photosensoren auf die Aufnahme von optischen, die Informationen übertragenden Signale vorbereitet wrrden.

5. Optische Tastatur nach anspruch 4, dadurch gekennzeichnet, daß die besagten Mittel zum Anlegen eines Licht-Vorsignals einen zusätzlichen Lichteingabe-Eingang enthalten, der mit jedem der Ausgänge über bleibende, ununterbrochene optische Pfade verbunden ist.

6. Optische Tastatur nach einem der Ansprüche 4 und 5, dadurch gekennzeichnet, daß die besagten Mittel zum Anlegen eines Licht-Vorsignals das besagte Signal zu Beginn von jedem Überprüfungszyklus der Tastatur anlegen.

7. Optische Tastatur nach einem der Ansprüche 1 bis 6, dadurch gekennzeichnet, daß einige der Tasten, die "Kombinatoren" genannt sind, derart optischen Pfaden zugeordnet sind, daß ihr Zustand zu Beginn jedes Überprüfungszyklus für die Tastatur überprüft wird, um so ein Beschleunigen der nachfolgenden Überprüfung im Innern des Zyklus in dem Maße zu gestatten, indem es nicht nötig ist, Informationen über andere,"Nicht-Kombinatoren" genannte Tasten zu enthalten, bis alle Kombinator-TasteN geprüft worden sind.

8. Optische Tastatur nach einem der Ansprüche 2 bis 7, dadurch gekennzeichnet, daß die besagten, zum Erhöhen der Empgung der Photosensoren mit einer Spannung enthalten, die um ein Mehrfaches höher ist als die Referenz-Vorspannung des Steuerkeises.

9. Optische Tastatur nach einem der Ansprüche 1 bis 8, dadurch gekennzeichnet, daß jeder Ausgang an eine den Photosensor bildende Photodiode angeschlossen ist, die im Ausgang an eine MOS-Schaltung, die sie einerseits mit der Eingangskapazität auflöst, ur.d andererseits an eine Entladeschaltung für diese Kapazität gemäß einem auf Null rücksetzenden Signal angeschlossen ist.

**Claims**

1. A matrix scanning keyboard with increasing sensitivity comprising a matrix of optical paths between light inlets and light outlets with keys disposed on each optical path connecting an inlet to an outlet in such a manner that depressing a key causes a change of optical coupling between the inlet and the outlet of said path of light and a driver circuit having light emitters connected to said light inlets and photodetectors connected to said light outlets to register the changes of the light flow from interrogation signals periodically injected on each light inlet according to a predetermined scanning cycle and inspection of each outlet for the presence of possible modifications of the optical coupling said keyboard being characterized by the fact that it includes means, other than means controlling the supply voltage applied to said detectors, which are capable for a given emission level of increasing the sensitivity of said driver circuit to light arriving at said outlets.

2. An optical keyboard according to claim 1, characterized by the fact said means capable of increasing the driver circuit light sensitivity are constituted by means of an increase in the scanning duration available as optimized by a variable scanning rate capable of rising to speeds which are as high as possible compatible with proper operation.

3. An optical keyboard according to claim 2, characterized in that, when no keys are depressed, each scanning cycle of light source begins at the moment when to slowest of the photodetectors is ready to receive new information.

4. An optical keyboard according to one of the claims 1 to 3, characterized in that it includes means to apply on said outlets a light pre-signal increasing the sensitivity to prepare the phodetectors to receive the information optical signals.

5. An optical keyboard according to claim 4 characterized in that said means to apply a light pre-signal include an additional pre-signal injection inlet connected to each of said light outlets via permanent optical paths.

6. An optical keyboard according to claim 4 or 5, characterized in that said means to apply one light pre-signal, apply said signal at the beginning of keyboard scanning.

7. An optical keyboard according to one of the claims 1 to 6, characterized in that some of the keys, called as combining keys, are associated with optical paths so as that their state is examined at the beginning of each keyboard scanning to accelerate the further examination inside the scrutation scanning as far as there is no need to retain informations relating to the other key called "non-combining" until all the combining keys have been examined.

8. An optical keyboard according to any one of claims 2 to 7, characterized by the fact that said means for increasing the light sensitivity of the driver circuit consists in feeding the optical receiver transducers with a voltage which is several times greater than their reference voltage of the other parts of the driving circuit.

9. An optical keyboard according to any one of claims 1 to 8, characterized by the fact that on each outlet is connected a photodiode, constituting the photodetector, said photodiode being connected to a MOS circuit, the inlet capacitance of said MOS circuit being charged by the photodiode, a discharge circuit discharging said capaciting under control of a reset signal.

FIG.1

FIG.2

FIG.3

FIG. 4

FIG. 5